# EUROPEAN PATENT APPLICATION

(11) **EP 2 426 703 A1**
(43) Date of publication of application: **07.03.2012**
(21) Application number: 10769693.2
(22) Date of filing: 26.04.2010
(51) Int. Cl.: H01L 21/205, C23C 16/44, H01L 21/3065

(54) **PLASMA PROCESSING METHOD AND PLASMA PROCESSING APPARATUS**

(30) Priority: 30.04.2009 JP 2009110831
(71) Applicant: Sharp Kabushiki Kaisha, Osaka-shi, Osaka 545-8522 (JP)
(72) Inventor: ISSHIKI, Kazuhiko, Osaka-shi, Osaka (JP); KISHIMOTO, Katsushi, Osaka-shi, Osaka (JP)
(74) Representative: Müller - Hoffmann & Partner
(86) International application number: PCT/JP2010/057339
(87) International publication number: WO 2010/125995

(57) **Abstract**

A first step of supplying, for a certain period of time, AC electric power having a first value smaller than a value needed to perform plasma processing is carried out, in order to generate a plasma discharge between a cathode electrode (102) and an anode electrode (103). Subsequent to the first step, a second step of supplying AC electric power greater than the first value is carried out. The second step includes the step of supplying, for a certain period of time, AC electric power having a second value at which the plasma processing can be performed. Subsequent to the second step, a third step of supplying AC electric power having a third value greater than the second value for a certain period of time is carried out.

## Description

### TECHNICAL FIELD

The present invention relates to a plasma processing method and a plasma processing apparatus.

### BACKGROUND ART

Etching by plasma processing, i.e., plasma etching, has conventionally been widely performed. For example, Japanese Patent Laying-Open No. 2007-207925 discloses a method that uses both of a plasma etching apparatus and a plasma CVD (Chemical Vapor Deposition) apparatus.

According to this technique, a film is first formed on a workpiece by plasma CVD. The workpiece is then removed, and plasma etching is performed for the purpose of cleaning off the film deposited on an anode electrode and a cathode electrode.

### CITATION LIST

### PATENT LITERATURE

PTL 1: Japanese Patent Laying-Open No. 2007-207925

### SUMMERY OF INVENTION

### TECHNICAL PROBLEM

The cleaning described above is desirably performed at an increased etching rate in a shorter period of time, in order to improve productivity. In order to thus improve the time efficiency of plasma processing, it is necessary to increase the electric power supplied to the electrode pair. However, if the power is simply increased, the electrodes may be deformed by heat produced by the large amount of electric power.

Accordingly, an object of the present invention is to provide a plasma processing method and a plasma processing apparatus capable of suppressing deformation of the electrodes while improving the time efficiency of plasma processing.

### SOLUTION TO PROBLEM

The plasma processing method of the present invention is a plasma processing method for performing plasma processing by using a plasma processing apparatus having a cathode electrode and an anode electrode disposed within a sealed container to face each other with a distance therebetween, and a gas-introducing pipe for introducing a process gas into the container, and by supplying AC electric power to the cathode electrode at which the plasma processing can be performed. The method has the following steps.

A first step of supplying, for a certain period of time, AC electric power having a first value smaller than a value needed to perform the plasma processing is carried out, in order to generate a plasma discharge between the cathode electrode and the anode electrode. Subsequent to the first step, a second step of supplying AC electric power greater than the first value is carried out. The second step includes the step of supplying, for a certain period of time, AC electric power having a second value at which the plasma processing can be performed. Subsequent to the second step, a third step of supplying AC electric power having a third value greater than the second value for a certain period of time is carried out.

According to the plasma processing method of the present invention, the plasma processing can be performed with improved efficiency by carrying out the third step of supplying AC electric power having a third value greater than the second value for a certain period of time. Prior to the third step, the second step of supplying, for a certain period of time, AC electric power having a second value smaller than the third value is carried out, thereby causing the temperature of the electrodes to increase more gradually, allowing deformation of the electrodes to be suppressed. Furthermore, both of the first and second steps can contribute to the plasma processing, allowing the time efficiency of the plasma processing to be improved.

Preferably, the second step further includes, prior to the step of supplying the AC electric power having the second value for a certain period of time, the step of supplying, for a certain period of time, AC electric power having a fourth value smaller than the second value and at which the plasma processing can be performed.

Preferably, the cathode electrode includes a first member having a plurality of through-holes for introducing the process gas into the container, and a second member mounted on the first member, and a gap communicating with the gas-introducing pipe and interconnecting the plurality of through-holes is provided between the first and second members.

This allows the process gas to be uniformly supplied while suppressing deformation of the electrodes.

Preferably, the process gas is either a film-forming gas or an etching gas.

Preferably, the above-described plasma processing method includes, prior to the first step, the step of forming a film using a film-forming gas as the process gas. In the step of forming a film, a deposit is formed on at least any of the cathode electrode and the anode electrode. The first to third steps are carried out using an etching gas as the process gas, and the deposit is etched by the second and third steps.

This allows deformation of the electrodes to be suppressed, while improving the time efficiency of removing the deposit.

Preferably, the etching gas is a mixed gas of a reactive gas for performing reactive etching and a diluent gas for diluting the reactive gas. When the AC electric power supplied to the cathode electrode is increased, a ratio D/R of a flow rate D of the diluent gas to a flow rate R of the reactive gas is reduced, and, when the AC electric power has a constant value, the ratio D/R is also made constant.

This suppresses an abnormal plasma discharge, thus stabilizing the etching.

The plasma processing apparatus of the present invention is capable of performing cleaning treatment for removing the above-described deposit according to the above-described plasma processing method.

### ADVANTAGEOUS EFFECTS OF INVENTION

According to the present invention, deformation of the electrodes can be suppressed while improving the time efficiency of the plasma processing.

### BRIEF DESCRIPTION OF DRAWINGS

Fig. 1 is a cross-sectional view schematically showing a film-forming method in a plasma processing method according to one embodiment of the present invention.
Fig. 2 is a cross-sectional view schematically showing a cleaning method in the plasma processing method according to one embodiment of the present invention.
Fig. 3 is a graph schematically showing temporal changes in power density in the cleaning method of Fig. 2.
Fig. 4 is a graph schematically showing temporal changes in power density in the first comparative example.
Fig. 5 is a graph schematically showing the relation between power density and an etching rate.
Fig. 6 is a graph schematically showing temporal changes in the increasing temperature of the cathode for each of different power densities.
Fig. 7 is a cross-sectional view schematically showing deformation of the electrodes in the plasma processing method of the first comparative example.
Fig. 8 is a graph schematically showing temporal changes in power density in the second comparative example.

### DESCRIPTION OF EMBODIMENTS

One embodiment of the present invention will hereinafter be described with reference to the drawings.

### (First Embodiment)

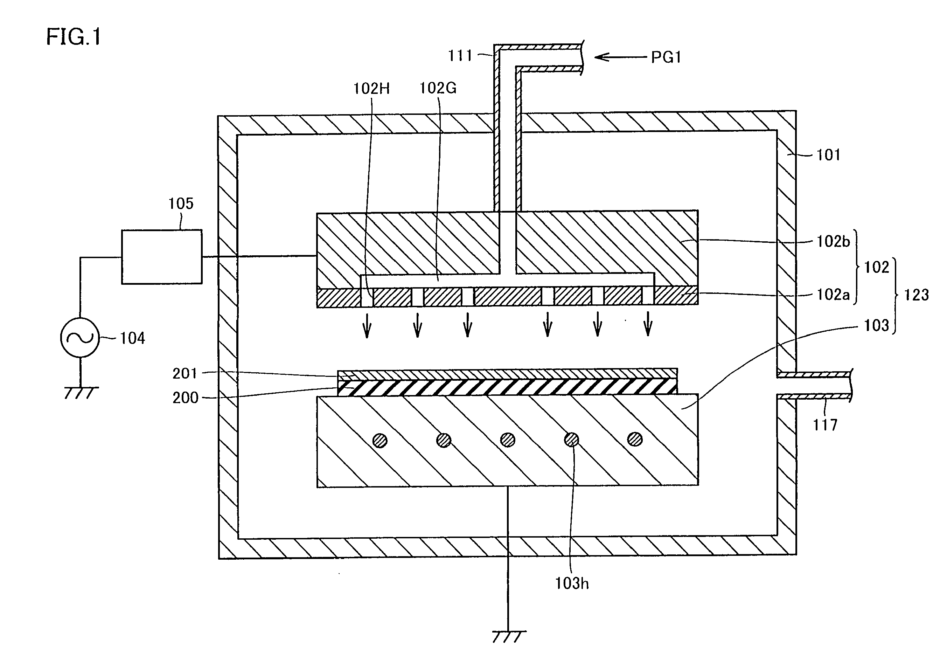

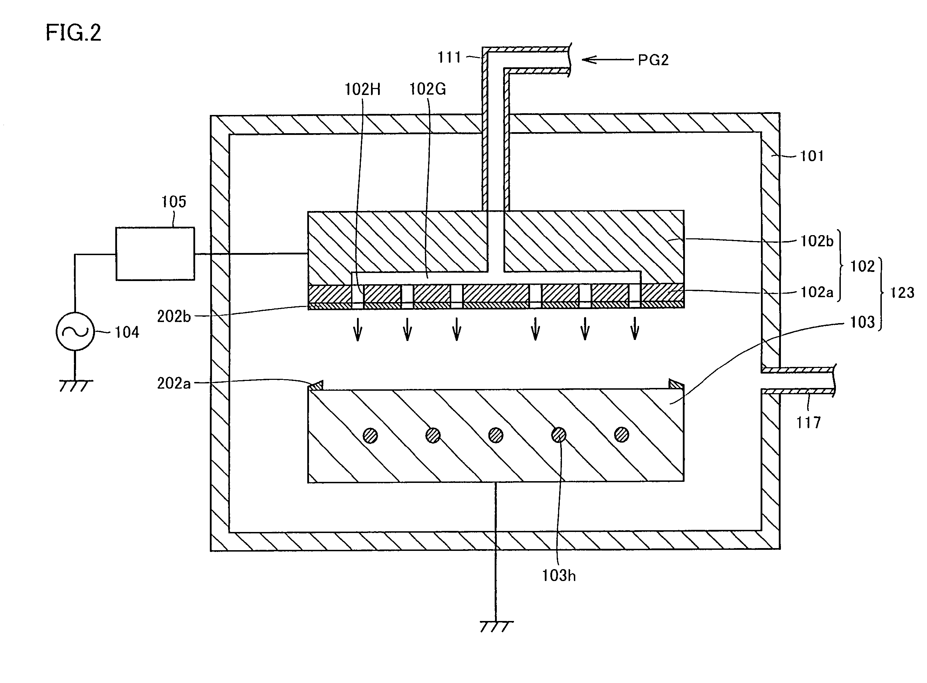

Referring to Figs. 1 and 2, a plasma processing apparatus of the present embodiment is capable of forming a film by chemical vapor deposition (Fig. 1), and of performing plasma etching (Fig. 2); more specifically, the plasma processing apparatus is capable of forming a silicon thin film, and of performing etching for cleaning off any deposits formed on the apparatus during the formation of such a film.

The plasma processing apparatus has a container 101, an electrode pair 123, an AC power supply 104, a matching circuit 105, a gas-introducing pipe 111, and a gas-exhaust pipe 117.

Container 101 is for providing a sealed space for performing plasma processing. The degree of vacuum of container 101 can be maintained at an optimum value by exhausting gases through gas-exhaust pipe 117.

Electrode pair 123 has a cathode electrode 102 (a first electrode) and an anode electrode 103 (a second electrode). Cathode electrode 102 and anode electrode 103 are facing each other with a distance therebetween, and form electrode pair 123.

Cathode electrode 102 is connected to AC power supply 104 via matching circuit 105. AC power supply 104 is for supplying AC electric power between cathode electrode 102 and anode electrode 103, and is, for example, an RF (Radio Frequency) power supply. Matching circuit 105 is for performing impedance-matching between electrode pair 123 and AC power supply 104.

Cathode electrode 102 also has a shower plate 102a (a first member) and a base material 102b (a second member). Shower plate 102a has a plurality of through-holes 102H for supplying a process gas. Base material 102b is mounted on shower plate 102a. A gap 102G that interconnects the plurality of through-holes 102H is provided between shower plate 102a and base material 102b. Gap 102G is connected to gas-introducing pipe 111. Using this configuration, a film-forming gas PG1 (Fig. 1), which is a process gas for film formation, or an etching gas PG2 (Fig. 2), which is a process gas for etching, can be uniformly introduced between cathode electrode 102 and anode electrode 103 within container 101 through the plurality of through-holes 102H.

Anode electrode 103 is grounded, and is configured to support a substrate 200 that is to be plasma-processed. Anode electrode 103 also has a heater 103h for heating substrate 200. Substrate 200 is, for example, a glass substrate.

Gas-exhaust pipe 117 has one end connected to container 101 and the other end connected to a vacuum pump (not shown). This allows container 101 to be maintained at a pressure not more than the atmospheric pressure.

Next, a film-forming method in a plasma processing method according to the present embodiment will be described.

Referring to Fig. 1, substrate 200 is placed on anode electrode 103. Film-forming gas PG1 is then introduced from gas-introducing pipe 111. Film-forming gas PG1 is a mixed gas of SiH₄ gas, which is a source gas, and H₂ gas, which is a diluent gas. Film-forming gas PG1 introduced into container 101 is exhausted through gas-exhaust pipe 117. The balance between the introduction rate of film-forming gas PG1 and the gas-exhaust rate through gas-exhaust pipe 117 is controlled, thereby controlling the pressure within container 101 to, for example, about several hundred Pa. A discharge is subsequently induced between electrode pair 123, causing a silicon thin film 201 to be formed on substrate 200 by plasma CVD. After the completion of the film formation, the discharge and the introduction of film-forming gas PG1 are stopped. Substrate 200 is then carried out of container 101.

Mainly referring to Fig. 2, during the film formation described above, deposits 202a and 202b are formed on a portion of anode electrode 103 that has been uncovered with substrate 200 (Fig. 1) and cathode electrode 102, respectively. Deposits 202a and 202b can cause the generation of dust that may deteriorate the quality of silicon thin film 201. For this reason, the following plasma etching processing is performed, in order to remove deposits 202a and 202b.

First, etching gas PG2 is introduced from gas-introducing pipe 111. Etching gas PG2 is a mixed gas of a reactive gas for performing reactive etching and a diluent gas for diluting the reactive gas, and is, for example, a mixed gas of NF₃ gas, which is a cleaning gas (a reactive gas), and Ar gas, which is a diluent gas. Etching gas PG2 introduced into container 101 is exhausted through gas-exhaust pipe 117. The balance between the introduction rate of etching gas PG2 and the gas-exhaust rate through gas-exhaust pipe 117 is controlled, thereby controlling the pressure within container 101. The pressure is preferably less than 600 Pa, and more preferably less than 200 Pa.

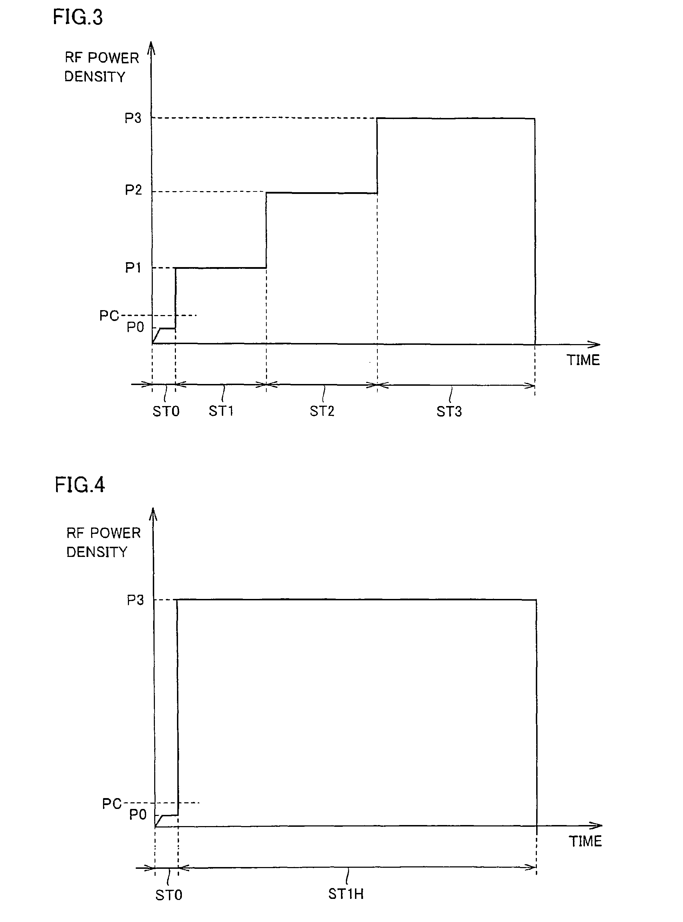

Further referring to Fig. 3, at a step ST0, electric power needed to initiate a discharge between electrode pair 123 is supplied from AC power supply 104, thus causing a discharge to be initiated between electrode pair 123. The power density of this electric power (AC electric power having a first value), i.e., the electric power per opposing area of electrode pair 123, is defined as a power density P0, which is, for example, 0.5 kW/m². Power density P0 is not more than a power density PC. Power density PC is an upper limit value of a power density that is sufficient to initiate a discharge, but is insufficient to substantially perform etching processing. Power density PC is, for example, 10% of the maximum power density used in the plasma processing. The maximum power density is, for example, not less than 0.5 kW/m² and not more than 4 kW/m².

At a step ST1, AC electric power at a power density P1 greater than power density PC (AC electric power having a fourth value) is continuously supplied to electrode pair 123. That is, during step ST1, AC electric power having one value is continuously supplied to electrode pair 123. This causes substantial plasma etching processing of deposits 202a and 202b to be initiated. The duration of step ST1 is, for example, not less than 5 minutes and not more than 30 minutes.

At a step ST2, AC electric power at a power density P2 greater than power density P1 (AC electric power having a second value) is supplied to electrode pair 123. For example, power density P2 is 1.5 kW/m², and the duration of step ST2 is not less than 5 minutes and not more than 30 minutes.

At a step ST3, AC electric power at a power density P3 greater than power density P2 (AC electric power having a third value) is supplied to electrode pair 123. For example, power density P2 is 4 kW/m², and the duration of step ST2 is not less than 5 minutes and not more than 30 minutes. In the present embodiment, power density P3 corresponds to the maximum power density in the plasma processing. Subsequent to step ST3, the discharge and the introduction of etching gas PG2 are stopped.

Plasma etching processing is performed as described above.

Note that a ratio D/R of a flow rate D of the diluent gas to a flow rate R of the cleaning gas may vary among steps ST1 to ST3.

Preferably, a ratio D2/R2 of a flow rate D2 of the diluent gas to a flow rate R2 of the cleaning gas in step ST2 is smaller than a ratio D1/R1 of a flow rate D1 of the diluent gas to a flow rate R1 of the cleaning gas in step ST1. This suppresses an abnormal plasma discharge, thus stabilizing the etching.

Specifically, a ratio R:D of flow rate R of the NF₃ gas, which is a cleaning gas, to flow rate D of the Ar gas, which is a diluent gas, is 1:20 in step ST 1, 1:10 in step ST2, and 2:5 in step ST3.

While the etching processing is performed in the three steps from steps ST1 to ST3, in the present embodiment, a greater number of steps may be used so as to increase the power density more gradually.

The total time of the etching processing is set, for example, to 2 hours or more, in order to perform sufficient etching.

A first comparative example will be described next.

Referring to Figs. 3 and 4, in the first comparative example (Fig. 4), a step ST1H is carried out instead of steps ST1 to ST3 of the present embodiment (Fig. 3). In step ST1H, subsequent to step ST0, etching processing is performed at the above-described power density P3. That is, subsequent to step ST0 and prior to the etching processing at power density P3 that corresponds to the maximum power density, etching processing at a constant power density smaller than power density P3 is not performed.

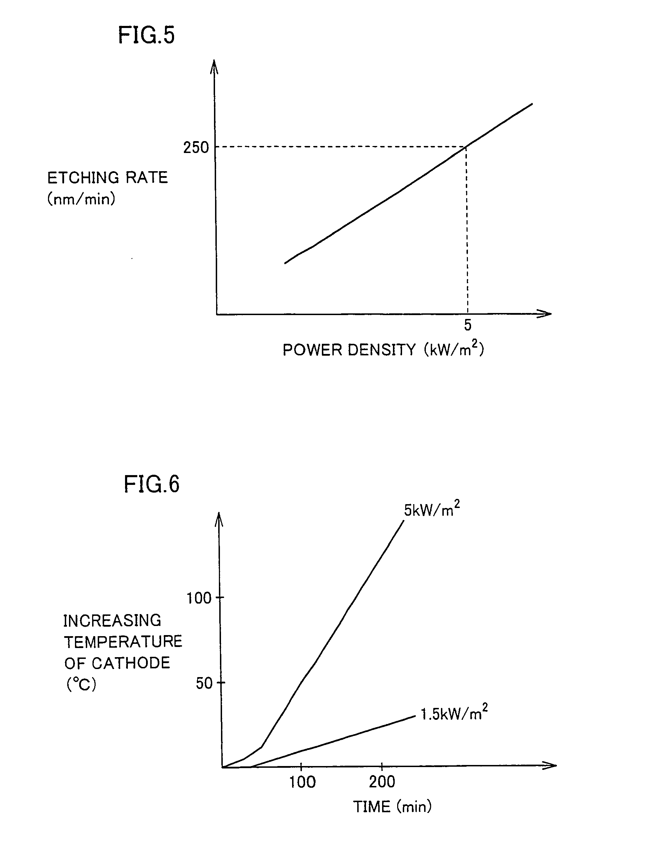

Referring to Fig. 5, there is an approximately proportional relation between power density and an etching rate. For this reason, more efficient etching processing is possible if the etching processing at a constant power density smaller than power density P3 is not performed subsequent to step ST0, as in the first comparative example (Fig. 4).

Referring to Fig. 6, the use of a greater power density causes the temperature of cathode electrode 102 (Fig. 2) to increase more sharply. Therefore, in the first comparative example, because the etching processing at a constant power density smaller than power density P3 is not performed, the temperature of cathode electrode 102 increases more sharply.

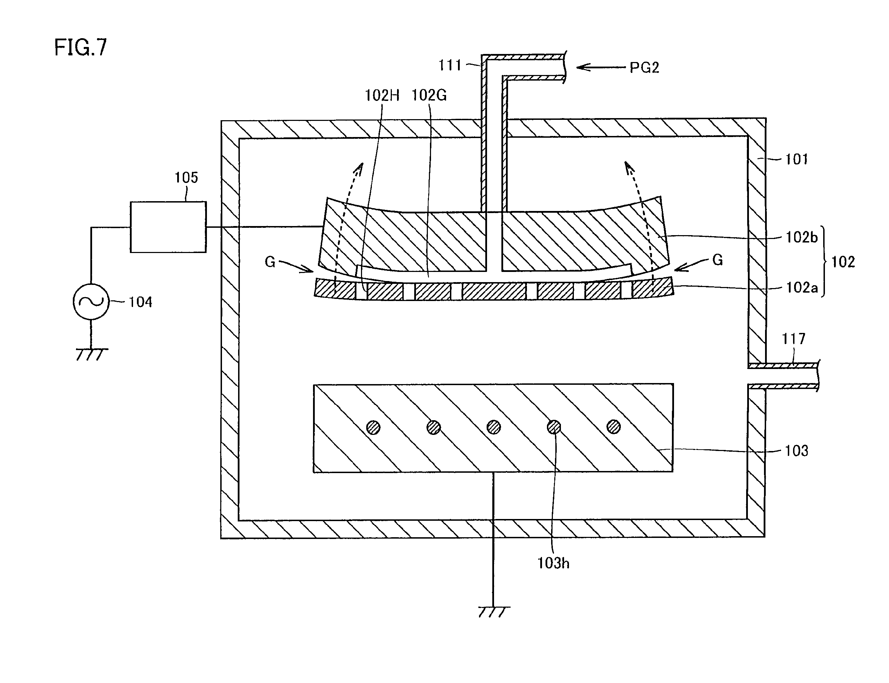

Referring to Fig. 7, when the temperature of cathode electrode 102 increases due to the plasma processing, a difference in temperature is produced in a thickness direction of cathode electrode 102. This difference in temperature increases due to the above-described sharp increase in the temperature of cathode electrode 102, consequently causing warping of cathode electrode 102 to easily occur, as indicated by the dashed arrows in Fig. 7. This warping also sometimes causes peeling between shower plate 102a and base material 102b, as indicated by an arrow G.

A second comparative example will be described next.

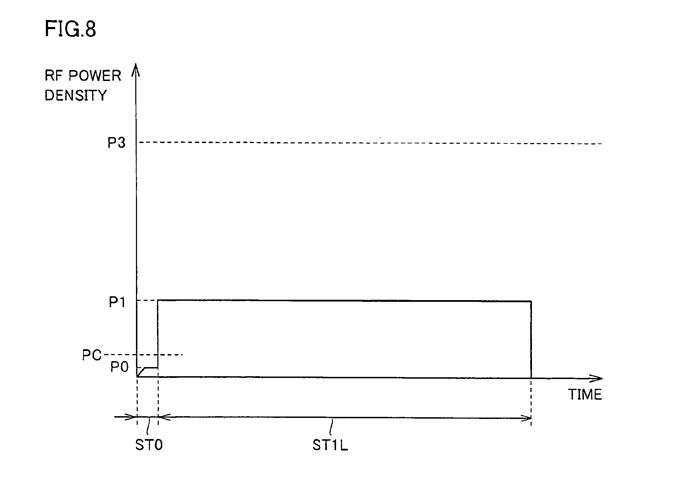

Referring to Figs. 3 and 8, in the second comparative example (Fig. 8), a step ST1L is carried out instead of steps ST1 to ST3 of the present embodiment (Fig. 3). In step ST1L, subsequent to step ST0, etching processing is performed at the above-described power density P1. That is, etching processing is completed after the etching processing at constant power density P1 smaller than power density P3 has been solely performed.

Referring to Fig. 5, there is an approximately proportional relation between power density and an etching rate. For this reason, the efficiency of etching processing decreases if the etching processing at power density P1 smaller than power density P3 is solely performed subsequent to step ST0, as in the second comparative example (Fig. 8).

Table 1 below shows the features of the etching processing according to each of the present embodiment (Fig. 3), the first comparative example (Fig. 4), and the second comparative example (Fig. 8) described above.

**[Table 1]**

| | RF Power | Etching Rate | Increase in Cathode Temperature | Warping of Cathode |
|---|---|---|---|---|
| Present Embodiment | Low → Medium | Medium | Within Acceptable Range | No |
| First Comparative Example | High | High | Overheating | Yes |
| Second Comparative Example | Low | Low | Within Acceptable Range | No |

According to the present embodiment, plasma processing can be performed with improved efficiency by using power density P2 greater than power density P1 in step ST2, as shown in Fig. 3. Moreover, plasma processing can be performed with improved efficiency by using power density P3 greater than power density P2 in step ST3.

Furthermore, the use of power density P1 smaller than power density P2 in step ST1 causes the temperature of cathode electrode 102 to increase more gradually. Accordingly, deformation of cathode electrode 102 can be suppressed.

Furthermore, because power density P1 in step ST1 is greater than power density PC, power density P1 can not only cause the temperature of cathode electrode 102 to increase more gradually, but can also contribute to the etching processing. Therefore, the time efficiency of the plasma processing can be improved.

It should be understood that the embodiments disclosed herein are illustrative and non-restrictive in every respect. The scope of the present invention is defined by the terms of the claims, rather than the description above, and is intended to include any modifications within the scope and meaning equivalent to the terms of the claims.

### INDUSTRIAL APPLICABILITY

The present invention is particularly advantageously applicable to a plasma processing method using an electrode pair.

### REFERENCE SIGNS LIST

101: container, 102: cathode electrode, 102a: shower plate (first member), 102b: base material (second member), 102H: through-hole, 102G: gap, 103: anode electrode, 103h: heater, 104: AC power supply, 105: matching circuit, 111: gas-introducing pipe, 117: gas-exhaust pipe, 123: electrode pair, 200: substrate, 201: silicon thin film, 202a: deposit.

## Claims

1. A plasma processing method for performing plasma processing by using a plasma processing apparatus having a cathode electrode (102) and an anode electrode (103) disposed within a sealed container (101) to face each other with a distance therebetween, and a gas-introducing pipe (111) for introducing a process gas into said container (101), and by supplying AC electric power to said cathode electrode (102) at which the plasma processing can be performed, the method comprising:
a first step of supplying, for a certain period of time, AC electric power having a first value smaller than a value needed to perform said plasma processing, in order to generate a plasma discharge between said cathode electrode (102) and said anode electrode (103);
a second step of supplying AC electric power greater than said first value subsequent to said first step, said second step including the step of supplying, for a certain period of time, AC electric power having a second value at which said plasma processing can be performed; and
a third step of supplying AC electric power having a third value greater than said second value for a certain period of time subsequent to said second step.

2. The plasma processing method according to claim 1, wherein
said second step further includes the step of supplying, for a certain period of time, AC electric power having a fourth value smaller than said second value and at which said plasma processing can be performed prior to said step of supplying the AC electric power having said second value for a certain period of time.

3. The plasma processing method according to claim 1 or 2, wherein
said cathode electrode (102) includes a first member (102a) having a plurality of through-holes (102H) for introducing said process gas into said container (101), and a second member (102b) mounted on said first member (102a), and a gap (102G) communicating with said gas-introducing pipe (111) and interconnecting said plurality of through-holes (102H) is provided between said first and second members (102a, 102b).

4. The plasma processing method according to any of claims 1 to 3, wherein said process gas is either a film-forming gas or an etching gas.

5. The plasma processing method according to any of claims 1 to 3, further comprising, prior to said first step, a step of forming a film using a film-forming gas as said process gas, wherein
in said step of forming a film, a deposit (202a) is formed on at least any of said cathode electrode (102) and said anode electrode (103), and
said first to third steps are carried out using an etching gas as said process gas, and said deposit (202a) is etched by said second and third steps.

6. The plasma processing method according to claim 5, wherein
said etching gas is a mixed gas of a reactive gas for performing reactive etching and a diluent gas for diluting said reactive gas, and
when the AC electric power supplied to said cathode electrode (102) is increased, a ratio D/R of a flow rate D of said diluent gas to a flow rate R of said reactive gas is reduced, and, when the AC electric power has a constant value, said ratio D/R is also made constant.

7. A plasma processing apparatus capable of performing cleaning treatment for removing said deposit (202a) according to the plasma processing method of claim 5 or 6.
